# EUROPEAN PATENT APPLICATION

(11) **EP 2 945 187 A1**
(43) Date of publication of application: **18.11.2015**
(21) Application number: 13870949.8
(22) Date of filing: 25.12.2013
(51) Int. Cl.: H01L 21/205, C23C 16/34, C30B 29/38, H01L 33/16, H01L 33/22, H01L 33/32

(54) **CRYSTAL LAYERED STRUCTURE AND LIGHT EMITTING ELEMENT**

(30) Priority: 11.01.2013 JP 2013003941
(71) Applicant: Tamura Corporation, Tokyo 178-8511 (JP); Koha Co., Ltd., Tokyo 178-8511 (JP)
(72) Inventor: MORISHIMA, Yoshikatsu, Tokyo 178-8511 (JP); SATO, Shinkuro, Tokyo 178-8511 (JP); GOTO, Ken, Tokyo 178-8511 (JP); IIZUKA, Kazuyuki, Tokyo 178-8511 (JP); KURAMATA, Akito, Tokyo 178-8511 (JP)
(74) Representative: Betten & Resch
(86) International application number: PCT/JP2013/084683
(87) International publication number: WO 2014/109233

(57) **Abstract**

Provided are: a crystal layered structure which has a Ga₂O₃ substrate and a nitride semiconductor layer and is capable of providing a light emitting element having high light output; and a light emitting element which comprises this crystal layered structure. According to one embodiment of the present invention, there is provided a crystal layered structure (1) which comprises: a Ga₂O₃ substrate (2); a dielectric layer (3) which is formed on the Ga₂O₃ substrate (2) so as to partially cover the upper surface of the Ga₂O₃ substrate (2), and which has a refractive index difference of 0.15 or less relative to the Ga₂O₃ substrate (2); and a nitride semiconductor layer (4) which is formed on the Ga₂O₃ substrate (2) with the dielectric layer (3) being interposed therebetween, and which is in contact with the dielectric layer (3) and a portion of the upper surface of the Ga₂O₃ substrate (2), said portion being not covered by the dielectric layer (3).

## Description

### [Technical Field]

The invention relates to a crystal layered structure and a light emitting element.

### [Background Art]

For forming some conventional light emitting elements, it is known that a crystal film is grown on a rugged surface of a translucent substrate (see, e.g., PTL 1). In PTL 1, a GaN-based semiconductor layer is grown on a rugged surface of a sapphire substrate.

The rugged pattern of the sapphire substrate in PTL **1** has a function of suppressing reflection of light emitted from a light-emitting layer in the GaN-based semiconductor layer, which occurs at an interface between the sapphire substrate and the GaN-based semiconductor layer due to a difference in refractive index between the sapphire substrate and the GaN-based semiconductor layer. Suppression of such reflection allows absorption of the reflected light by the light-emitting layer and attenuation of the reflected light due to multiple reflection to be reduced, thereby improving light extraction efficiency of the light emitting element.

### [Citation List]

### [Patent Literature]

### [PTL 1]

JP-B-3595277

### [Summary of Invention]

### [Technical Problem]

It is an object of the invention to provide a crystal layered structure that includes a Ga₂O₃ substrate and a nitride semiconductor layer so as to have a light emitting element with a high light output, as well as a light emitting element including the crystal layered structure.

### [Solution to Problem]

According to one embodiment of the invention, a crystal layered structure set forth in [1] to [5] below is provided so as to achieve the object.

[1] A crystal layered structure, comprising:
   a Ga₂O₃ substrate;
   a dielectric layer that is formed on the Ga₂O₃ substrate so as to partially cover an upper surface of the Ga₂O₃ substrate and has a refractive index difference of not more than **0.15** relative to the Ga₂O₃ substrate; and
   a nitride semiconductor layer that is formed on the Ga₂O₃ substrate with the dielectric layer interposed therebetween and is in contact with the dielectric layer and a portion not covered by the dielectric layer on the upper surface of the Ga₂O₃ substrate.
[2] The crystal layered structure according to [1], wherein the dielectric layer comprises a SiN layer comprising SiN as a main component.
[3] The crystal layered structure according to [1] or [2], wherein the nitride semiconductor layer comprises a GaN layer.
[4] The crystal layered structure according [3], wherein the upper surface of the nitride semiconductor layer comprises a **(002)** plane orientation.
[5] The crystal layered structure according to [1] or [2], wherein the thickness of the dielectric layer is not less than **0.5** µm.
   According to another embodiment of the invention, a light emitting element set forth in [6] below is provided so as to achieve the object.
[6] A light emitting element, comprising the crystal layered structure according to [1] or [2],
   wherein the Ga₂O₃ substrate and the nitride semiconductor layer are configured to conduct electricity therethrough.

### [Advantageous Effects of Invention]

According to the invention, a crystal layered structure can be provided that includes a Ga₂O₃ substrate and a nitride semiconductor layer so as to have a light emitting element with a high light output, as well as a light emitting element including the crystal layered structure.

### [Brief Description of Drawings]

**[****FIG.1****]**

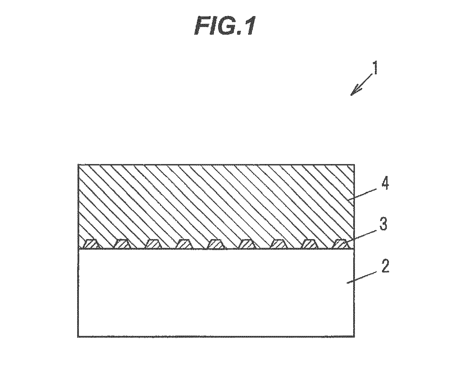

   **FIG.1** is a vertical cross-sectional view showing a crystal layered structure in a first embodiment.
**[****FIG.2A****]**

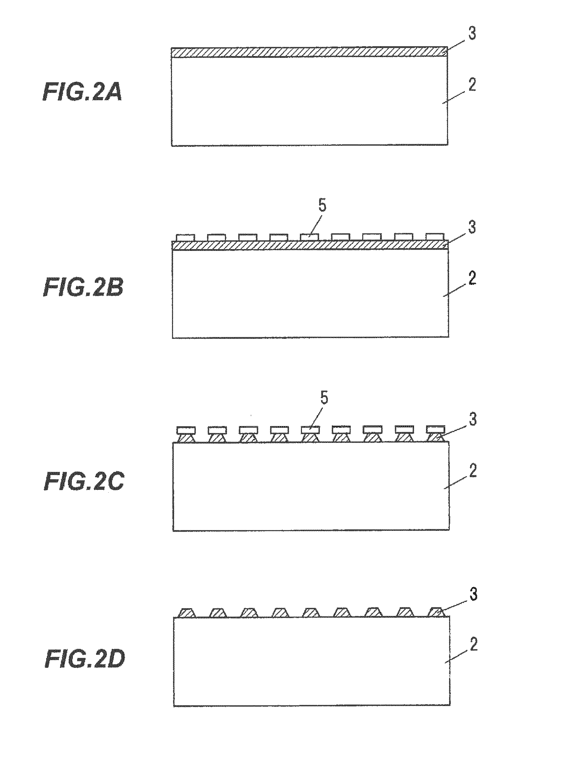

   **FIG.2A** is a vertical cross-sectional view showing a process of manufacturing the crystal layered structure in the first embodiment.
**[****FIG.2B****]**
   **FIG.2B** is a vertical cross-sectional view showing a process of manufacturing the crystal layered structure in the first embodiment.
**[****FIG.2C****]**
   **FIG.2C** is a vertical cross-sectional view showing a process of manufacturing the crystal layered structure in the first embodiment.
**[****FIG.2D****]**
   **FIG.2D** is a vertical cross-sectional view showing a process of manufacturing the crystal layered structure in the first embodiment.
**[****FIG.3A****]**

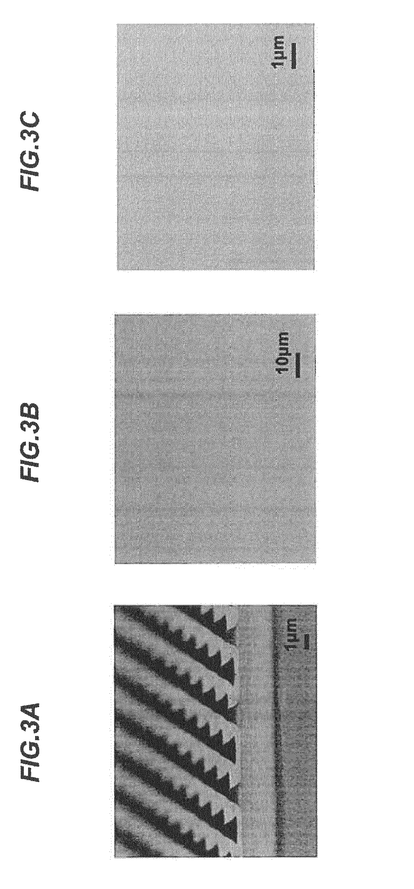

   **FIG.3A** is a SEM image showing the crystal layered structure in the first embodiment before formation of a nitride semiconductor layer.
**[****FIG.3B****]**
   **FIG.3B** is a SEM image showing the crystal layered structure in the first embodiment after formation of the nitride semiconductor layer.
**[****FIG.3C****]**
   **FIG.3C** is a SEM image showing the crystal layered structure in the first embodiment after formation of the nitride semiconductor layer.
**[****FIG.4A****]**

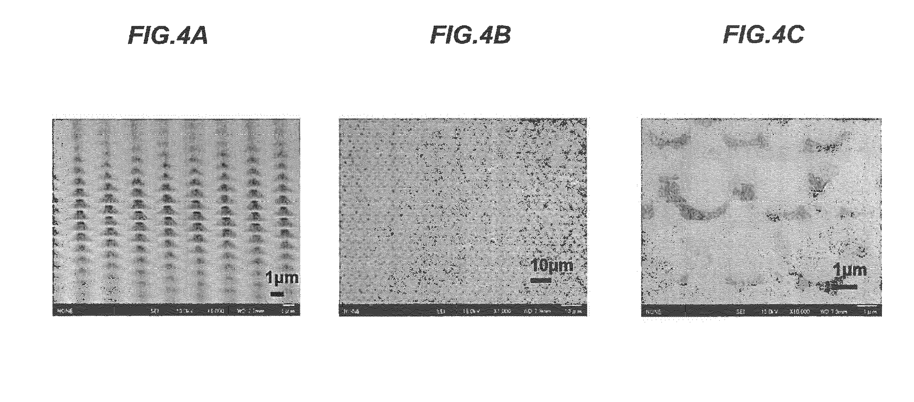

   **FIG.4A** is a SEM image showing a crystal layered structure in Comparative Example before formation of a nitride semiconductor layer.
**[****FIG.4B****]**
   **FIG.4B** is a SEM image showing the crystal layered structure in Comparative Example after formation of the nitride semiconductor layer.
**[****FIG.4C****]**
   **FIG.4C** is a SEM image showing the crystal layered structure in Comparative Example after formation of the nitride semiconductor layer.
**[****FIG.5****]**

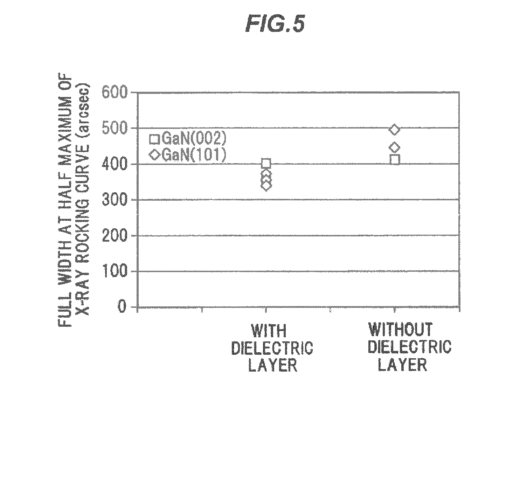

   **FIG.5** is a graph showing full widths at half maximum (FWHMs) of x-ray rocking curves from the nitride semiconductor layer of the crystal layered structure in the first embodiment and those in Comparative Example.
**[****FIG6****]**

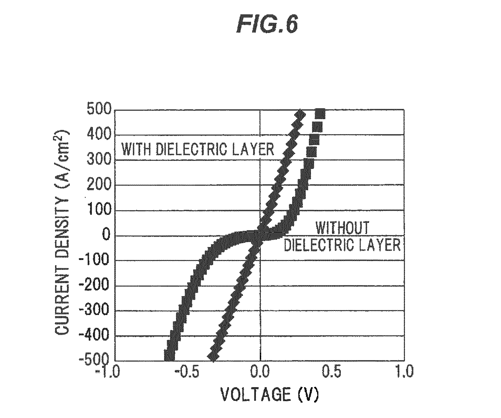

   **FIG.6** is a graph showing vertical current-voltage characteristics of the crystal layered structures in the first embodiment and Comparative Example when a dielectric layer is a SiN layer.
**[****FIG.7****]**

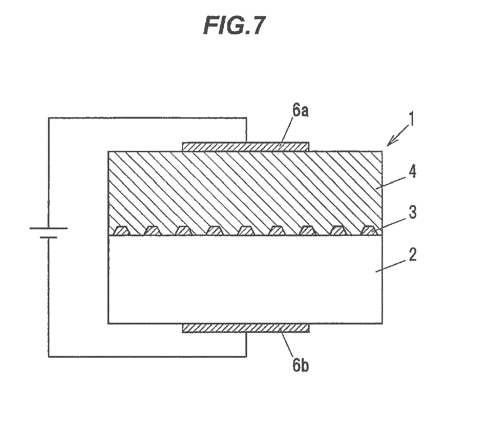

   **FIG.7** is a vertical cross-sectional view showing the crystal layered structure to which electrodes are connected to measure current-voltage characteristics.
**[****FIG.8****]**

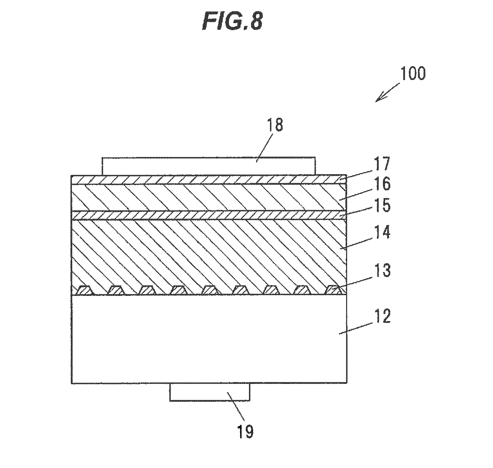

   **FIG.8** is a vertical cross-sectional view showing a light emitting element in a second embodiment.
**[****FIG.9****]**

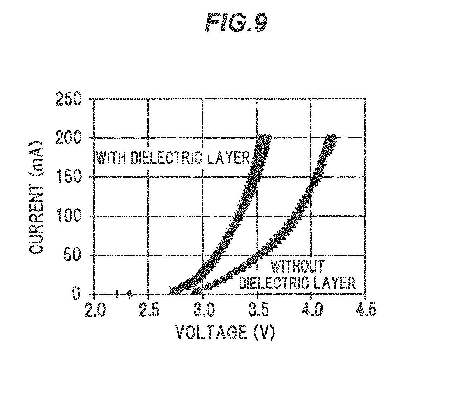

   **FIG.9** is a graph showing vertical current-voltage characteristics of the light emitting elements in the second embodiment and Comparative Example when a dielectric layer is a SiN layer.
**[****FIG.10****]**

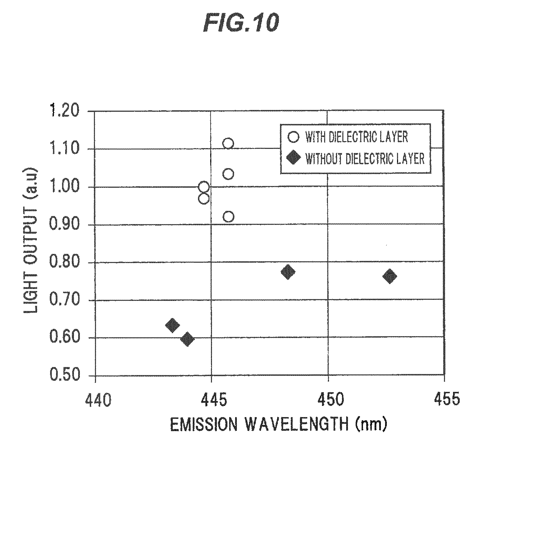

   **FIG.10** is a graph showing light output characteristics of the light emitting elements in the second embodiment and Comparative Example.
**[****FIG.11****]**

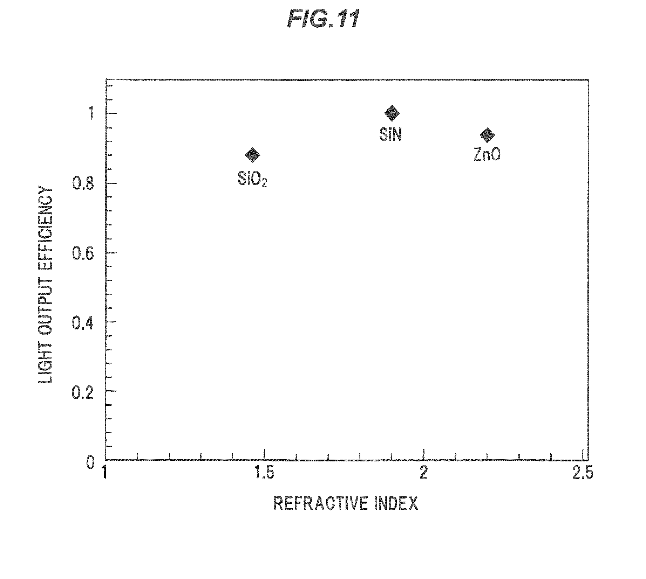

   **FIG.11** is a graph obtained based on optical simulations and showing an example of a relation between a material of the dielectric layer and light extraction efficiency of the light emitting element.

### [Description of Embodiments]

For forming a crystal layered structure having a Ga₂O₃ substrate and a nitride semiconductor layer, a method may be devised in which a rugged pattern is formed on a surface of the Ga₂O₃ substrate and a nitride semiconductor crystal is then grown thereon for the purpose of reducing light reflection which occurs at an interface between the Ga₂O₃ substrate and the nitride semiconductor layer due to a difference in refractive index between the Ga₂O₃ substrate and the nitride semiconductor layer.

However, the inventors have found that when growing a nitride semiconductor crystal on a rugged surface of the Ga₂O₃ substrate, the obtained nitride semiconductor layer does not have high crystal quality. One of the reasons is considered that the Ga₂O₃ substrate has only limited crystal planes which allow a high-quality nitride semiconductor crystal to be grown. When a rugged pattern is formed on the upper surface of the Ga₂O₃ substrate, various crystal planes including those unsuitable as a base for growing a high-quality nitride semiconductor crystal are formed and a nitride semiconductor layer with high crystal quality is thus not obtained.

As a result of intense study to solve such a problem, the present inventors made the present invention of which embodiments will be described below as an example.

### [First embodiment]

### (Configuration of Crystal layered structure)

**FIG.1** is a vertical cross-sectional view showing a crystal layered structure in the first embodiment. A crystal layered structure 1 includes a Ga₂O₃ substrate 2, a dielectric layer **3** on the Ga₂O₃ substrate **2** and a nitride semiconductor layer **4** on the dielectric layer **3.**

The Ga₂O₃ substrate **2** is formed of a β-Ga₂O₃ single crystal. The upper surface of the Ga₂O₃ substrate **2** is a flat surface without rugged pattern and is oriented to **(101), (-201)** or (100), etc., which can provide a base for growing a high-quality nitride semiconductor crystal. A refractive index of the Ga₂O₃ substrate **2** is about **1.9.**

The dielectric layer **3** is a layer having a refractive index difference of not more than **0.15** relative to the Ga₂O₃ substrate **2** and is, e.g., a SiN layer consisting mainly of SiN or an HfO₂ layer consisting mainly of HfO₂. If the refractive index of the Ga₂O₃ substrate 2 is e.g. **1.9,** the refractive index of the dielectric layer **3** is to be not less than **1.75** and not more than **2.05.**

The dielectric layer **3** is formed on the Ga₂O₃ substrate **2** so as to partially cover the upper surface of the Ga₂O₃ substrate **2.** The pattern shape of the dielectric layer **3** is not limited and is, e.g., a dot pattern, a hole pattern or a line-and-space pattern.

Since the refractive index of the dielectric layer **3** is close to that of the Ga₂O₃ substrate **2,** reflectivity at an interface between the Ga₂O₃ substrate **2** and the dielectric layer **3** is small. The SiN layer provided as the dielectric layer **3** may contain elements other than Si and N, such as O, but is preferably formed of substantially only SiN to further reduce a difference between the refractive index of the dielectric layer 3 and that of the Ga₂O₃ substrate **2.**

In addition, the refractive index of the dielectric layer 3 is preferably not more than that of the Ga₂O₃ substrate **2** so that total reflection of light traveling from the dielectric layer **3** toward the Ga₂O₃ substrate **2** is prevented.

The refractive index of the dielectric layer **3** can be adjusted by controlling the conditions for forming the dielectric layer **3,** such as film-forming temperature, to reduce the difference between the refractive index of the dielectric layer **3** and that of the Ga₂O₃ substrate 2.

When, e.g., a SiO₂ layer having a large refractive index difference relative to the Ga₂O₃ substrate 2 is formed in place of the dielectric layer **3,** reflectivity at an interface between the SiO₂ layer and the Ga₂O₃ substrate **2** is large and transmittance of light is decreased between the Ga₂O₃substrate **2** and the nitride semiconductor layer **4.** The SiO₂ layer has a refractive index of about **1.5** to **1.6** and thus has the refractive index difference of not less than 0.3 relative to the Ga₂O₃ substrate **2.**

The nitride semiconductor layer **4** is formed of a nitride semiconductor crystal, i.e., an AlₓGa_{y}In_{z}N (**0**≤x≤**1**, **0**≤y≤**1**, **0**≤z≤**1**, x+y+z=**1**) crystal. In the configuration of the crystal layered structure **1** in the present embodiment, crystal quality of the nitride semiconductor layer **4** is particularly high when a GaN layer formed of a GaN crystal (y=**1**, x=z=**0**) is used as the nitride semiconductor layer **4.**

The nitride semiconductor layer **4** may have a multilayer structure in which plural layers formed of different nitride semiconductor crystals are laminated. When the crystal layered structure **1** is used to form, e.g., a light emitting element, cladding layers and a light-emitting layer sandwiched therebetween, etc., may be included in the nitride semiconductor layer **4.**

The Ga₂O₃ substrate **2** and the nitride semiconductor layer **4** may contain a conductive impurity such as Si.

Since the upper surface of the Ga₂O₃ substrate **2** is used as a base to form the nitride semiconductor layer **4,** the dielectric layer **3** does not entirely cover the upper surface of the Ga₂O₃ substrate **2.** The nitride semiconductor layer **4** is in contact with the dielectric layer **3** as well as the upper surface of the Ga₂O₃ substrate **2** at a portion not covered by the dielectric layer **3.**

A nitride semiconductor crystal constituting the nitride semiconductor layer **4** is grown from the upper surface of the Ga₂O₃ substrate **2** in a region not covered by the dielectric layer **3,** and is not grown from the dielectric layer **3.** Since the nitride semiconductor layer **4** is formed by such selective growth of the nitride semiconductor crystal, dislocation density in the nitride semiconductor layer **4** is reduced and crystal quality is thus improved. The crystal growth method using such selective growth is called ELO (Epitaxial Lateral Overgrowth), etc.

The thickness of the dielectric layer **3** for improving transmittance is determined according to a wavelength of light incident on the dielectric layer **3** from the nitride semiconductor layer **4.** The thickness of the dielectric layer **3** is desirably greater than the wavelength. When, for example, the crystal layered structure **1** having a SiN layer as the dielectric layer **3** is used to form a light emitting element in which a light-emitting layer having an emission wavelength of about **400** nm is included in the nitride semiconductor layer **4,** the thickness of the dielectric layer **3** is preferably not less than **0.5** µm.

In the crystal layered structure **1,** light is easily transmitted between the nitride semiconductor layer **4** and the dielectric layer **3** due to the rugged pattern of the dielectric layer **3.** In addition, light is easily transmitted also between the dielectric layer **3** and the Ga₂O₃ substrate **2** due to a small refractive index difference between the dielectric layer **3** and the Ga₂O₃ substrate **2.** Therefore, in the crystal layered structure 1, transmittance of light is high between the Ga₂O₃ substrate **2** and the nitride semiconductor layer **4.**

### (Method of manufacturing Crystal layered structure)

A manufacturing process when using a SiN layer as the dielectric layer **3** will be described below as an example of the process of manufacturing the crystal layered structure in the present embodiment.

**FIGS.2A** to **2D** are vertical cross-sectional views showing a process of manufacturing the crystal layered structure in the first embodiment.

Firstly, the Ga₂O₃ substrate **2** treated by CMP (Chemical Mechanical Polishing) is subjected to organic cleaning, SPM (Sulfuric acid/hydrogen peroxide mixture) cleaning and HF solution cleaning.

Next, the Ga₂O₃ substrate **2** is transferred to a chamber of a MOCVD (Metal Organic Chemical Vapor Deposition) system.

Next, as shown in **FIG.2A****,** the dielectric layer **3** in the form of film is formed on the Ga₂O₃ substrate **2.** SiN is deposited on the Ga₂O₃ substrate **2** by supplying SiH₄ as a Si raw material, NH₃ gas as an N raw material and N₂ gas as an atmosphere gas into the chamber in a state that the temperature in the chamber is maintained at **300** to **350°C,** thereby forming the dielectric layer **3** in the form of film. At this stage, the dielectric layer **3** is a film having a substantially uniform thickness of about **1** µm. The raw materials of the respective elements are not limited to those mentioned above.

Next, as shown in **FIG.2B****,** a resist pattern **5** is formed on the dielectric layer **3.** The pattern shape of the resist pattern **5** is, e.g., a dot pattern with **2** µm-diameter dots at a pitch of **3** µm, but may be another pattern such as hole pattern or line-and-space pattern. The resist pattern **5** is formed by, e.g., photolithography.

Next, as shown in **FIG.2C****,** the dielectric layer **3** is etched with BHF (buffered hydrofluoric acid) using the resist pattern **5** as a mask, thereby transferring the pattern of the resist pattern **5** to the dielectric layer **3.**

Next, as shown in **FIG.2D****,** the remained resist pattern **5** is removed. After that, an AIₓGa_{y}In_{z}N crystal as a nitride semiconductor crystal is selectively grown on the Ga₂O₃ substrate **2** by supplying NH₃ gas as an N raw material, trimethylgallium (TMG) gas as a Ga raw material, trimethylaluminum (TMA) gas as an A1 raw material and trimethylindium (TMI) gas as an In raw material into the chamber, thereby forming the nitride semiconductor layer **4.** As a result, the crystal layered structure **1** is obtained.

The following is a specific example of the manufacturing method when the nitride semiconductor layer **4** is composed of a buffer layer formed of an AlGaInN crystal and a GaN layer thereon. Firstly, the surface of a structure composed of the Ga₂O₃ substrate **2** and the dielectric layer **3** is cleaned by organic cleaning and SPM cleaning and the structure is introduced into the MOCVD system. Then, using NH₃ gas as an N raw material, trimethylgallium (TMG) as a Ga raw material, trimethylaluminum (TMA) as an Al raw material, trimethylindium (TMI) as an In raw material and Si as an n-type impurity, a low-temperature AlGaN buffer layer is formed while maintaining the temperature of the substrate surface at around **500°C.** After that, the temperature of the substrate surface is increased to around **1000°C** to form an initial n-GaN core which is then continuously grown to about **2** µm. Then, a **2** µm-thick n-GaN layer is formed at an elevated substrate surface temperature of around **1100°C,** thereby obtaining the nitride semiconductor layer **4.**

### (Characteristics of Crystal layered structure)

**FIG.3A** is a SEM (Scanning Electron Microscope) image showing the crystal layered structure in the first embodiment before formation of a nitride semiconductor layer, and **FIGS.3B** and **3C** are SEM images after formation of the nitride semiconductor layer.

**FIG.3A** shows the Ga₂O₃ substrate **2** and a SiN layer as the dielectric layer **3,** and **FIGS.3B** and **3C** show a GaN layer having an upper surface oriented to **(002)** as the nitride semiconductor layer 4.

**FIG.4A** is a SEM image showing the crystal layered structure in Comparative Example before formation of a nitride semiconductor layer, and **FIGS.4B** and **4C** are SEM images after formation of the nitride semiconductor layer.

In the crystal layered structure in Comparative Example show in **FIG.4****,** the upper surface of the Ga₂O₃ substrate 2 is processed to have a rugged pattern, instead of forming the dielectric layer **3.** **FIG.4A** shows the Ga₂O₃ substrate **2** with a rugged upper surface and **FIGS.4B** and **4C** show a GaN layer having an upper surface oriented to **(002)** which is a layer corresponding to the nitride semiconductor layer **4** in the present embodiment.

**FIGS.3A** and **4A** are images of the upper surface of the Ga₂O₃ substrate **2** taken from obliquely above. Truncated cone-shaped objects in **FIG.3A** are a dot-patterned SiN constituting the dielectric layer **3.** Truncated cone-shaped objects in **FIG.4A** are raised portions on the dot-patterned upper surface of the Ga₂O₃ substrate 2.

**FIGS.3B** and **3C** show that the upper surface of the nitride semiconductor layer 4 in the present embodiment is flat and the nitride semiconductor layer **4** has high crystal quality. On the other hand, dark areas shown in **FIGS.4B** and **4C** are abnormally-grown portions of the crystal and it is understood that the nitride semiconductor layer in Comparative Example has poor crystal quality. This result shows that a nitride semiconductor layer with high crystal quality is obtained without abnormal growth by forming the dielectric layer **3** on a flat upper surface of the Ga₂O₃ substrate **2,** not by forming a rugged pattern on the upper surface of the Ga₂O₃ substrate **2.**

**FIG.5** is a graph showing FWHMs of x-ray rocking curves from the nitride semiconductor layer of the crystal layered structure in the first embodiment and those in Comparative Example.

Unlike the crystal layered structure **1** in the first embodiment, the crystal layered structure in Comparative Example shown in **FIG.5** does not include the dielectric layer **3** and is composed of only the Ga₂O₃ substrate **2** and a nitride semiconductor layer.

The dielectric layer 3 in the first embodiment which is used for measurement pertaining to **FIG.5** is a SiN layer. Meanwhile, both the nitride semiconductor layer **4** in the first embodiment and the nitride semiconductor layer in Comparative Example are formed of a GaN crystal and have an upper surface oriented to **(002).**

In **FIG.5****,** the measured values of the crystal layered structure **1** in the first embodiment are indicated on the left side above "with dielectric layer" and the measured values of the crystal layered structure in Comparative Example are indicated on the right side above "without dielectric layer".

In **FIG.5****,** FWHM of x-ray rocking curve from a **(002)** plane and that from a **(101)** plane perpendicular to the **(002)** plane are respectively indicated by "□ (open square)" and "◇ (open diamond)". FWHM of x-ray rocking curve from the **(002)** plane is to evaluate orientation of a plane parallel to the upper surface of the nitride semiconductor layer, while FWHM of x-ray rocking curve from the **(101)** plane is to evaluate orientation of a plane perpendicular to the upper surface of the nitride semiconductor layer.

As shown in **FIG.5****,** both FWHM of x-ray rocking curve from the **(002)** plane and that from the **(101)** plane are narrower in the crystal layered structure **1** having the dielectric layer **3** in the first embodiment than in the crystal layered structure not having the dielectric layer **3** in Comparative Example, especially remarkable in the results from the **(101)** plane. This result shows that crystal quality of the nitride semiconductor layer is improved by providing the dielectric layer **3.**

**FIG.6** is a graph showing vertical current-voltage characteristics of the crystal layered structures in the first embodiment and Comparative Example when a dielectric layer is a SiN layer. In **FIG.6****,** the horizontal axis indicates voltage (V) and the vertical axis indicates current density (A/cm²).

The dielectric layer **3** in the first embodiment which is used for measurement pertaining to **FIG.6** is a SiN layer. It has been confirmed that the crystal layered structure **1** has particularly excellent vertical current-voltage characteristics when the dielectric layer **3** is a SiN layer.

Unlike the crystal layered structure **1** in the first embodiment, the crystal layered structure in Comparative Example shown in **FIG.6** does not include the dielectric layer **3** formed of SiN and is composed of only a Ga₂O₃ substrate and a nitride semiconductor layer. Meanwhile, both the nitride semiconductor layer **4** in the first embodiment and the nitride semiconductor layer in Comparative Example are formed of a GaN crystal and have an upper surface oriented to **(002).**

In **FIG.6****,** the measured values of the crystal layered structure 1 in the first embodiment are indicated by "with SiN layer" and the measured values of the crystal layered structure in Comparative Example are indicated by "without SiN layer".

For measuring the current-voltage characteristics shown **in** **FIG.6****,** electrodes were respectively connected to a surface of the Ga₂O₃ substrate and a surface of the nitride semiconductor layer and voltage was applied in the vertical direction of the crystal layered structure. **FIG.7** shows a state in which electrodes are connected to the Ga₃O₃ substrate **2** and the nitride semiconductor layer **4** of the crystal layered structure **1.** Electrodes **6a** and **6b** were respectively connected to the Ga₂O₃ substrate **2** and the nitride semiconductor layer **4.** Electrodes were also connected to the crystal layered structure in Comparative Example in the same manner.

**FIG.6** shows that a potential barrier is present at an interface between the Ga₂O₃ substrate **2** and the nitride semiconductor layer in the crystal layered structure not having the dielectric layer **3** formed of SiN in Comparative Example while, in the crystal layered structure 1 having the dielectric layer **3** formed of SiN in the first embodiment, a potential barrier is not present at an interface between the Ga₂O₃ substrate **2** and the nitride semiconductor layer **4** and the Ga₂O₃ substrate **2** is in ohmic contact with the nitride semiconductor layer **4.** This result shows that vertical electrical resistance of the crystal layered structure **1** is reduced by providing the dielectric layer **3** formed of SiN.

The dielectric layer **3** formed of SiN in the first embodiment used for the images and the measurements of **FIGS.3****,** **5** and **6** was formed by a plasma CVD system (PD-220, manufactured by SAMCO Inc.) at a film-forming temperature of 300°C using SiH₄ gas, NH₃ gas and N₂ gas as process gases, and had a refractive index of **1.89.**

### (Effects of the first embodiment)

In the first embodiment in which the nitride semiconductor layer **4** is formed on the upper surface of the Ga₂O₃ substrate **2** having the dielectric layer **3** formed thereon, it is possible to improve transmittance of light between the nitride semiconductor layer **4** and the Ga₂O₃ substrate **2.** In addition, it is possible to improve crystal quality of the nitride semiconductor layer **4.** And, especially when the dielectric layer **3** is a SiN layer, it is possible to form an ohmic contact between the Ga₂O₃ substrate **2** and the nitride semiconductor layer **4.** Furthermore, in the present embodiment, it is possible to obtain improved crystal quality when a GaN layer is used as the nitride semiconductor layer **4.**

### [Second embodiment]

### (Configuration of Light emitting element)

The second embodiment is an embodiment of a light emitting element including the crystal layered structure **1** in the first embodiment. An example of the light emitting element will be described below.

**FIG.8** is a vertical cross-sectional view showing a light emitting element in the second embodiment. A light emitting element **100** is an LED element which has a Ga₂O₃ substrate **12,** a dielectric layer **13** on the Ga₂O₃ substrate **12,** an n-type cladding layer **14** on the dielectric layer **13,** a light-emitting layer **15** on the n-type cladding layer **14,** a p-type cladding layer **16** on the light-emitting layer **15,** a contact layer **17** on the p-type cladding layer **16,** a p-type electrode **18** on the contact layer **17** and an n-type electrode **19** on a surface of the Ga₂O₃ substrate **12** opposite to the dielectric layer **13.**

The Ga₂O₃ substrate **12** and the dielectric layer **13** respectively correspond to the Ga₂O₃ substrate **2** and the dielectric layer **3** in the first embodiment. The n-type cladding layer **14** is formed of a nitride semiconductor crystal. Therefore, at least the n-typc cladding layer **14** corresponds to the nitride semiconductor layer **4** in the first embodiment. In case that a layer(s) on the n-type cladding layer **14** is formed of a nitride semiconductor crystal, the n-type cladding layer **14** and the nitride semiconductor crystal layer(s) thereon correspond to the nitride semiconductor layer **4.** When, e.g., the n-type cladding layer **14,** the light-emitting layer **15,** the p-type cladding layer **16** and the contact layer **17** are formed of a nitride semiconductor crystal, all of these layers correspond to the nitride semiconductor layer **4.**

The light emitting element **100** is a vertical light emitting element in which electricity is conducted to the Ga₂O₃ substrate **12** and the above-mentioned layer(s) corresponding to the nitride semiconductor layer **4** during operation.

In the light emitting element **100** which is formed using the crystal layered structure **1** in the first embodiment, transmittance of light is high between the Ga₂O₃ substrate **12** corresponding to the Ga₂O₃ substrate **2** and the layers including the n-type cladding layer **14** and corresponding to the nitride semiconductor layer **4.** Therefore, when the light emitting element **100** is a face-down type light emitting element configured to extract light from the Ga₂O₃ substrate **12** side, light emitted from the light-emitting layer **15** and traveling toward the Ga₂O₃ substrate **12** is efficiently transmitted, allowing high light output to be obtained.

Meanwhile, when the light emitting element **100** is a face-up type light emitting element configured to extract light from the contact layer **17** side, it is possible to suppress reflection of light, which is emitted from the light-emitting layer **15** and traveling toward the Ga₂O₃ substrate **12,** at an interface between the n-type cladding layer **14** and the Ga₂O₃ substrate **12** and absorption of such light by the light-emitting layer **15,** etc. As a result, it is possible to obtain high light output.

### (Characteristics of Light emitting element)

Current-voltage characteristics and light output characteristics of the light emitting element **100** in the present embodiment will be described below in comparison to characteristics of a light emitting element in Comparative Example.

A specific configuration of the light emitting element **100** used for measuring the current-voltage characteristics and the light output characteristics will be described below.

The Ga₂O₃ substrate **12** is a **400** µm-thick n-type β-Ga₂O₃ substrate having an upper surface oriented to **(-201).** The dielectric layer **13** is a **1** µm-thick SiN layer having a refractive index of **1.89** and covering **15%** of the upper surface of the Ga₂O₃ substrate **12** in a region immediately under the n-type cladding layer **14.** The n-type cladding layer **14** is a **6** µm-thick n-type GaN crystal film. The light-emitting layer **15** is a layer composed of seven layers of **2.8** nm GaN crystal films and seven layers of **12** nm-thick InGaN crystal films which are alternately laminated. The p-type cladding layer **16** is a **0.2** µm-thick p-type GaN crystal film. The contact layer **17** is a **0.15** µm-thick p-type GaN crystal film.

The configuration of the light emitting element in Comparative Example is basically the same as the light emitting element **100** but the dielectric layer **13** is not provided.

**FIG.9** is a graph showing vertical current-voltage characteristics of the light emitting elements in the second embodiment and Comparative Example when a dielectric layer is a SiN layer. In **FIG.9****,** the horizontal axis indicates voltage (V) and the vertical axis indicates current (m/A).

The dielectric layer **13** in the second embodiment which is used for measurement pertaining to **FIG.9** is a SiN layer. It has been confirmed that the light emitting element **100** has particularly excellent vertical current-voltage characteristics when the dielectric layer **13** is a SiN layer.

As shown in **FIG.9****,** voltage required for a specific current is smaller in the light emitting element **100** having the dielectric layer **13** formed of SiN in the present embodiment than in the light emitting element not having the dielectric layer **13** formed of SiN in Comparative Example. This result shows that it is possible to reduce driving voltage of the light emitting element by providing the dielectric layer **13** formed of SiN.

**FIG.10** is a graph showing light output characteristics of the light emitting elements in the second embodiment and Comparative Example. In **FIG.10****,** the horizontal axis indicates emission wavelength (nm) and the vertical axis indicates light output (arbitrary unit). In this measurement, the p-type electrode **18** side of the light emitting element **100** was attached to a mount and total luminous flux was measured.

**FIG.10** shows that light output from the light emitting element **100** having the dielectric layer **13** in the present embodiment is larger than that from light emitting element not having the dielectric layer **13** in Comparative Example. This result shows that it is possible to improve light output of the light emitting element by providing the dielectric layer **13.**

It is considered that these results are obtained since, by providing the dielectric layer **13,** that crystal quality of the n-type cladding layer **14,** the light-emitting layer **15,** the p-type cladding layer **16** and the contact layer **17** all corresponding to the nitride semiconductor layer **4** is improved and also reflectivity at an interface between the Ga₂O₃ substrate **12** and the n-typc cladding layer **14** is reduced. The ohmic contact between the Ga₂O₃ substrate **12** and the n-type cladding layer **14,** which results from use of the SiN layer as the dielectric layer **13,** also largely contributes to such results.

**FIG.11** is a graph obtained based on optical simulations and showing an example of a relation between a material of the dielectric layer and light extraction efficiency of the light emitting element.

In the optical simulations, the Ga₂O₃ substrate **12** had a refractive index of **1.9,** a dielectric layer corresponding to the dielectric layer **13** had a dot pattern with dots of **2** µm in diameter and **1** µm in height at a pitch of **3** µm, and light emitted from the light-emitting layer was extracted from the Ga₂O₃ substrate 12 side. A SiO₂ layer (n=**1.46**), a SiN layer (n=**1.9**) and a ZnO layer (n=2.2) were used here as the dielectric layer. Of those, only the SiN layer satisfies the requirement for the refractive index of the dielectric layer 13 in the present embodiment.

The reference light extraction efficiency in **FIG.11** is light extraction efficiency when the light emitting element **100** in the present embodiment does not have the dielectric layer **13** but has the same rugged shape on the surface of the Ga₂O₃ substrate **12.** In this regard, however, the light extraction efficiency used as a reference is a theoretical value when assuming that the n-type cladding layer **14,** the light-emitting layer **15,** the p-type cladding layer **16** and the contact layer **17** all having good crystal quality are formed on the Ga₂O₃ substrate **12** having a rugged surface. It is difficult to form a nitride semiconductor layer with good crystal quality on a Ga₂O₃ substrate having a rugged surface as described using **FIG.4****,** and it is therefore practically difficult to obtain the n-type cladding layer **14,** the light-emitting layer **15,** the p-type cladding layer **16** and the contact layer **17** which have good crystal quality.

**FIG.11** shows that light extraction efficiency is the highest when a SiN layer satisfying the requirement for the refractive index of the dielectric layer **13** is used as the dielectric layer.

The optical simulations also show that light extraction efficiency is not less than **95%** of the reference value when the refractive index of the dielectric layer is not less than **1.75** and not more than **2.05,** i.e., when a difference in refractive index between the dielectric layer and the Ga₂O₃ substrate **2** is not more than **0.15.**

### (Effects of the second embodiment)

In the second embodiment, it is possible to obtain the light emitting element **100** having high light output and requiring low driving voltage by using the crystal layered structure **1** in the first embodiment in which the nitride semiconductor layer **4** has high crystal quality and the Ga₂O₃ substrate **2** is ohmic contact with the nitride semiconductor layer **4.**

Although the embodiments of the invention have been described, the invention is not intended to be limited to these embodiments, and the various kinds of modifications can be implemented without departing from the gist of the invention.

In addition, the invention according to claims is not to be limited to the embodiments. Further, it should be noted that all combinations of the features described in the embodiments are not necessary to solve the problem of the invention.

### [Industrial Applicability]

A crystal layered structure can be provided that includes a Ga₂O₃ substrate and a nitride semiconductor layer so as to have a light emitting element with a high light output, as well as a light emitting element including the crystal layered structure.

### [Reference Signs List]

- **1**: crystal layered structure
- **2, 12**: Ga₂O₃ substrate
- **3,13**: dielectric layer
- **4**: nitride semiconductor layer
- **100**: light emitting element

## Claims

1. A crystal layered structure, comprising:
a Ga₂O₃ substrate;
a dielectric layer that is formed on the Ga₂O₃ substrate so as to partially cover an upper surface of the Ga₂O₃ substrate and has a refractive index difference of not more than **0.15** relative to the Ga₂O₃ substrate; and
a nitride semiconductor layer that is formed on the Ga₂O₃ substrate with the dielectric layer interposed therebetween and is in contact with the dielectric layer and a portion not covered by the dielectric layer on the upper surface of the Ga₂O₃ substrate.

2. The crystal layered structure according to claim **1,** wherein the dielectric layer comprises a SiN layer comprising SiN as a main component.

3. The crystal layered structure according to claim **1** or **2,** wherein the nitride semiconductor layer comprises a GaN layer.

4. The crystal layered structure according claim **3,** wherein the upper surface of the nitride semiconductor layer comprises a **(002)** plane orientation.

5. The crystal layered structure according to claim **1** or **2,** wherein the thickness of the dielectric layer is not less than **0.5** µm.

6. A light emitting element, comprising the crystal layered structure according to claim **1** or **2,**
wherein the Ga₂O₃ substrate and the nitride semiconductor layer are configured to conduct electricity therethrough.
